# DEMANDE DE BREVET EUROPEEN

(11) **EP 3 667 723 A1**
(43) Date de publication de la demande: **17.06.2020**
(21) Numéro de dépôt: 19214599.3
(22) Date de dépôt: 09.12.2019
(51) Int. Cl.: H01L 27/02, H01L 29/87

(54) **DISPOSITIF DE COMMUTATION ET PROCÉDÉ DE FABRICATION D'UN TEL DISPOSITIF**

(30) Priorité: 11.12.2018 FR 1872694
(71) Demandeur: STMicroelectronics (Tours) SAS, 37100 Tours (FR)
(72) Inventeur: ARNAUD, Aurélie, 37540 SAINT-CYR-SUR-LOIRE (FR)
(74) Mandataire: Cabinet Beaumont

(57) **Abrégé**

La présente description concerne un dispositif de commutation (1) comprenant une première couche de silicium dopé au phosphore (103) sur et en contact avec une deuxième couche de silicium dopé à l'arsenic (102).

## Description

### Domaine technique

La présente description concerne de façon générale les circuits électroniques et plus particulièrement des dispositifs de commutation. La présente description concerne notamment des dispositifs de commutation adaptés à une utilisation comme dispositif de protection contre des décharges électrostatiques ou ESD (ElectroStatic Discharges).

### Technique antérieure

On connaît des dispositifs de commutation adaptés à une utilisation comme dispositif de protection contre des décharges électrostatiques susceptibles de se produire entre deux bornes d'un circuit électronique. Un tel dispositif est destiné à être connecté entre les deux bornes du circuit, et est configuré pour se fermer lorsqu'une décharge électrostatique se produit entre ces deux bornes. Cette fermeture, ou mise en conduction, du dispositif permet de protéger le circuit contre les décharges électrostatiques.

Les dispositifs de commutation connus souffrent de divers inconvénients, notamment lorsqu'ils sont utilisés comme dispositif de protection contre les décharges électrostatiques.

### Résumé de l'invention

Il existe un besoin d'un dispositif de commutation palliant au moins certains inconvénients des dispositifs de commutation connus.

En particulier, il existe un besoin d'un dispositif de commutation adapté à une utilisation en dispositif de protection contre les décharges électrostatiques palliant au moins certains inconvénients des dispositifs de protection contre les décharges électrostatiques connus.

Ainsi, un mode de réalisation prévoit un dispositif de commutation comprenant un empilement comportant successivement, en contact deux à deux, une troisième couche de silicium dopé de type P, une deuxième couche de silicium dopé à l'arsenic, une première couche de silicium dopé au phosphore et une quatrième couche de silicium dopé de type N.

Selon un mode de réalisation, le niveau de dopage de la première couche diminue en s'éloignant de la deuxième couche et en s'approchant de la quatrième couche.

Selon un mode de réalisation, à l'interface entre les première et quatrième couches, le niveau de dopage de la première couche est égal au niveau de dopage de la quatrième couche.

Selon un mode de réalisation, le dispositif comprend une première région dopée de type P et disposée dans la quatrième couche, du côté opposé à la première couche.

Selon un mode de réalisation, la troisième couche est connectée à une première borne du dispositif et la première région est connectée à une deuxième borne du dispositif.

Selon un mode de réalisation, le dispositif comprend en outre une deuxième région dopée de type P disposée dans la quatrième couche, du côté opposé à la première couche, et une troisième région dopée de type N disposée dans la deuxième région, du côté opposé à la première couche.

Selon un mode de réalisation, les deuxième et troisième régions sont connectées à la première borne du dispositif.

Selon un mode de réalisation, les première et deuxième bornes du dispositif sont destinées à être connectées à deux bornes respectives d'un circuit à protéger contre une décharge électrostatique.

Selon un mode de réalisation, le dispositif comprend une couche de silicium épitaxié sur et en contact avec un substrat en silicium, la deuxième couche étant située dans le substrat et la première couche s'étendant depuis la deuxième couche jusque dans la couche de silicium épitaxié, l'épaisseur de la couche de silicium épitaxié étant de préférence comprise entre 10 et 14 µm.

Selon un mode de réalisation, la troisième couche est située dans le substrat, la quatrième couche étant située dans la couche de silicium épitaxié.

Un autre mode de réalisation prévoit un procédé de fabrication d'un dispositif de commutation comprenant les étapes suivantes : a) former une couche de silicium dopé à l'arsenic en implantant des atomes d'arsenic dans un substrat de silicium dopé de type P ; b) former une couche de silicium dopé au phosphore dans la couche de silicium dopé à l'arsenic en implantant des atomes de phosphore dans la couche de silicium dopé à l'arsenic ; et c) faire croître, par épitaxie à partir du substrat, une couche de silicium dopé de type N.

Selon un mode de réalisation, l'étape a) comprend le dépôt d'un masque sur le substrat, les implantations des étapes a) et b) étant effectuées en utilisant le masque.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière très schématique et en coupe, un mode de réalisation d'un dispositif de commutation ;
la figure 2 représente, de manière schématique, un circuit équivalent au dispositif de commutation de la figure 1 ;
la figure 3 représente des vues A, B et C illustrant des étapes successives d'un mode de réalisation d'un procédé de fabrication d'un dispositif de commutation du type de celui de la figure 1 ;
la figure 4 représente une courbe illustrant la variation du niveau de dopage dans le dispositif de la figure 1, le long d'un axe AA de la figure 1 ; et
la figure 5 représente deux courbes illustrant, lors d'une décharge électrostatique, l'évolution temporelle d'une tension aux bornes respectivement du dispositif de commutation de la figure 1 et d'un exemple de dispositif de commutation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les divers circuits électroniques à protéger contre des décharges électrostatiques n'ont pas été décrits, les modes de réalisation décrits étant compatibles avec les circuits électroniques usuels à protéger contre les décharges électrostatiques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

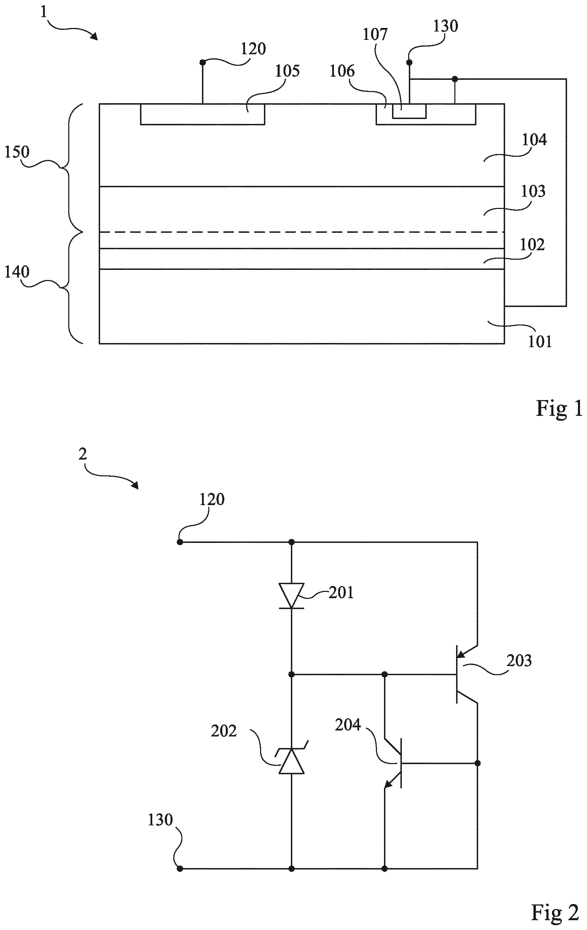

La figure 1 représente, de manière très schématique et en coupe, un mode de réalisation d'un dispositif de commutation 1. En particulier, le dispositif 1 est adapté à une utilisation comme dispositif de protection contre les décharges électrostatiques, par exemple des décharges électrostatiques définies par la norme IEC 6100, partie 4-2, ou par l'un des modèles parmi le modèle HBM (Human Body Model), le modèle MM (Machine Model) et le modèle CDM (Charged Device Model).

Le dispositif 1 comprend un empilement de couches de silicium dopé. L'empilement comprend successivement, du bas vers le haut en figure 1, une couche 101 de silicium dopé de type P, une couche 102 de silicium dopé à l'arsenic, une couche 103 de silicium dopé au phosphore et une couche 104 de silicium dopé de type N, les couches étant en contact deux à deux. Le niveau de dopage de la couche 102 est supérieur à celui de la couche 104, le niveau de dopage de la couche 103 étant compris entre le niveau de dopage de la couche 102 et celui de la couche 104. En outre, le niveau de dopage de la couche 103 diminue quand on s'éloigne de la couche 102. De préférence, le niveau de dopage de la couche 103 diminue à partir d'une valeur maximale correspondant au niveau de dopage de la couche 102 au niveau de la limite, ou interface, entre les couches 102 et 103. De préférence, le niveau de dopage de la couche 103 diminue jusqu'à la couche 104 de sorte que, à la limite entre les couches 103 et 104, le niveau de dopage de la couche 103 soit sensiblement égal, de préférence égal, à celui de la couche 104. Autrement dit, la limite entre les couches 103 et 104 correspond par exemple au passage d'une région (couche 103) avec un niveau de dopage diminuant en s'éloignant de la couche 102 à une région (couche 104) avec un niveau de dopage sensiblement constant, de préférence constant.

Le dispositif 1 comprend en outre, à gauche en figure 1, une région 105 dopée de type P. La région 105 s'étend dans la couche 104 à partir de la surface supérieure de celle-ci, sur une partie seulement de l'épaisseur de la couche 104. Autrement dit, la région 105 est disposée dans la couche 104, du côté opposé à la couche 103.

La région 105 est couplée, de préférence connectée, à une borne 120 du dispositif 1. La couche 101 est couplée, de préférence connectée, à une borne 130 du dispositif 1. Lorsque le dispositif est utilisé pour protéger un circuit électronique contre des décharges électrostatiques, par exemple un circuit électronique appartenant à la même puce de circuit intégré que le dispositif 1, les bornes 120 et 130 sont destinées à être couplées, de préférence connectées, à deux bornes respectives du circuit entre lesquelles une décharge électrostatique est susceptible de se produire. De préférence, la borne 130 du dispositif 1 est destinée à être couplée, de préférence connectée, à une borne du circuit reliée à la masse.

Dans cet exemple de mode de réalisation, le dispositif 1 comprend en outre, à droite en figure 1, une région 106 dopée de type P. La région 106 pénètre dans la couche 104 à partir de la surface supérieure de celle-ci, sur une partie seulement de l'épaisseur de la couche 104. Autrement dit, la région 106 est disposée dans la couche 104, du côté opposé à la couche 103. Le dispositif comprend également une région 107 dopée de type N. La région 107 pénètre dans la région 106 à partir de la surface supérieure de celle-ci, c'est-à-dire la face supérieure de la couche 104, sur une partie seulement de l'épaisseur de la région 106. Autrement dit, la région 107 est disposée dans la région 106, du côté opposé à la couche 103. Les régions 106 et 107 sont couplées, de préférence connectées, à la borne 130 du dispositif 1.

Dans cet exemple de mode de réalisation, l'empilement des couches 101, 102, 103, 104 et 105 est situé, c'est-à-dire formé, dans un ensemble comprenant un substrat en silicium 140 et une couche de silicium épitaxié 150 reposant sur et en contact avec le substrat 140, l'interface entre le substrat 140 et la couche 150 étant matérialisée par des traits pointillés en figure 1. Comme cela est représenté en figure 1, les couches 101 et 102 sont situées dans le substrat 140, la couche 104 étant située dans la couche 150. En outre, la couche 103 est formée dans la couche 102, du côté de la couche 140, et se propage dans la couche 104. Elle se situe donc à cheval entre le substrat 140 et la couche 150.

La figure 2 représente, de manière schématique, un circuit 2 équivalent au dispositif de commutation de la figure 1. Dans le circuit 2, les résistances et/ou les capacités intrinsèques du dispositif 1 n'ont pas été représentées.

Le circuit 2 comprend deux diodes 201 et 202 connectées en série entre les bornes 120 et 130. L'anode de la diode 201 correspond à la région 105 du dispositif 1 de la figure 1 et est couplée, de préférence connectée, à la borne 120, la cathode de la diode 201 correspondant à la couche 104 du dispositif 1. L'anode de la diode 202 correspond à la couche 101 du dispositif 1 et est couplée, de préférence connectée, à la borne 130, la cathode de la diode 202 correspondant à la couche 102 du dispositif 1. Les cathodes des diodes 201 et 202 sont reliées l'une à l'autre par l'intermédiaire de la couche 103. De préférence, la diode 202 est une diode de suppression de tensions transitoires ou diode TVS (Transient Voltage Suppression), aussi désignée par la marque ou l'appellation Transil.

Dans cet exemple où le dispositif comprend les régions 106 et 107, le circuit 2 comprend en outre deux transistors bipolaires 203 et 204.

Le transistor 203 est un transistor bipolaire de type PNP dont les régions de base, collecteur et émetteur correspondent respectivement à la couche 104 dopée de type N, à la région 106 dopée de type P et à la région 105 dopée de type P. Ainsi, l'émetteur du transistor 203 est couplé, de préférence connecté, à la borne 120, le collecteur du transistor 203 étant couplé, de préférence connecté, à la borne 130. En outre, la base du transistor 203 est reliée aux cathodes des diodes 201 et 202 par l'intermédiaire de la couche 104.

Le transistor 204 est un transistor bipolaire de type NPN dont les régions de base, collecteur et émetteur correspondent respectivement à la région 106 dopée de type P, à la couche 104 dopée de type N et à la région 107 dopée de type N. Ainsi, l'émetteur du transistor 204 est couplé, de préférence connecté, à la borne 130, le collecteur du transistor 204 étant relié aux cathodes des diodes 201 et 202 et à la base du transistor 203 par l'intermédiaire de la couche 104. En outre, la base du transistor 204 est reliée au collecteur du transistor 203 par l'intermédiaire de la région 106.

Les transistors 203 et 204 du dispositif 1 forment un thyristor ou SCR (Silicon Controlled Rectifier) dont l'anode est couplée, de préférence connectée, à la borne 120, et dont la cathode est couplée, de préférence connectée, à la borne 130, la gâchette du thyristor correspondant à la région 106 dopée de type P et étant couplée, de préférence connectée, à la borne 130 du dispositif 1.

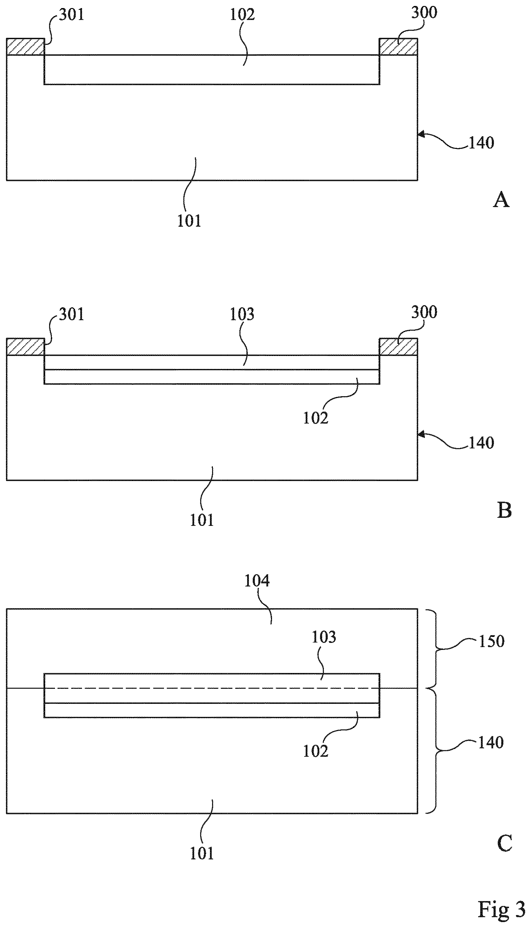

La figure 3 représente des vues A, B et C illustrant des étapes successives d'un mode de réalisation d'un procédé de fabrication d'un dispositif de commutation du type de celui de la figure 1.

A l'étape de la vue A, on prévoit un substrat 140 en silicium dopé de type P, par exemple au bore. Le substrat 140 correspond par exemple à une tranche de silicium. La couche 102 est formée dans le substrat 140 en dopant le substrat par implantation d'arsenic. La partie du substrat 140 sous la couche 102 correspond alors à la couche 101 décrite en relation avec la figure 1.

Dans ce mode de réalisation, préalablement à l'implantation d'arsenic, un masque 300 est déposé sur la surface supérieure du substrat 140. Le masque comprend une ouverture 301 à chaque emplacement du substrat 140 où l'on souhaite former un dispositif 1, l'implantation d'arsenic ayant lieu uniquement au niveau de chaque ouverture 301.

A l'étape de la vue B, la couche 103 est formée dans le substrat 140, et plus particulièrement dans la couche 102, en dopant le substrat par implantation de phosphore. La couche 103 est formée sur une partie seulement de l'épaisseur de la couche 102. La couche 103 est formée du côté de la face supérieure de la couche 102, c'est-à-dire du côté de la face supérieure du substrat 140. De préférence, le phosphore est implanté avec une dose inférieure à celle de l'arsenic, de sorte que le niveau de dopage de la couche 103 soit inférieur à celui de la couche 102. De préférence, le phosphore est implanté avec une énergie d'implantation inférieure à celle de l'arsenic de sorte que la couche 103 pénètre moins profondément dans le substrat 140 que la couche 102. Ainsi, la tension d'avalanche de la diode 202 est déterminée par les niveaux de dopage de la couche 102 et du substrat 140, c'est-à-dire de la couche 101.

Dans ce mode de réalisation, le masque 300 est réutilisé lors de l'implantation du phosphore, l'implantation du phosphore ayant donc lieu uniquement au niveau de chaque ouverture 301 du masque 300.

A l'étape de la vue C, le masque 300 est retiré puis une couche de silicium 150 est formée par épitaxie à partir du substrat 140. La couche de silicium 150 est dopée de type N, avec un niveau de dopage inférieur à celui de la couche 103 à l'étape précédente. De préférence, la couche de silicium épitaxié 150 est dopée in-situ, c'est-à-dire lors de la croissance épitaxiale du silicium, avec un niveau de dopage correspondant à celui de la couche 104.

Comme cela est représenté dans la vue C de la figure 3, du fait que le niveau de dopage du silicium épitaxié 150 est inférieur à celui de la couche 103 formée à l'étape de la vue B de la figure 3, les atomes de phosphore de la couche 103 diffusent dans le silicium épitaxié 150. Il en résulte que la couche 103 pénètre dans la couche 150, et que le niveau de dopage dans la couche 103 diminue en s'éloignant de la couche 102. Au-dessus de la couche 103, la partie de la couche 150 dans laquelle ne pénètre pas la couche 103 correspond à la couche 104 décrite en relation avec la figure 1. On notera qu'aucune étape de traitement thermique n'est prévue spécifiquement pour que les atomes de phosphore diffusent dans le silicium épitaxié 150, les atomes de phosphore diffusant dans le silicium épitaxié 150 pendant l'épitaxie et pendant d'éventuelles étapes ultérieures de traitement thermique.

A des étapes suivantes non illustrées, la région 105, et, dans cet exemple, les régions 106 et 107 sont formées lors d'étapes de dopage en elles-mêmes habituelles.

Dans le procédé décrit ci-dessus, du fait que le même masque 300 est utilisé pour l'implantation d'arsenic et pour l'implantation de phosphore, la couche 103 est formée sans prévoir de masque supplémentaire par rapport à un procédé de fabrication d'un dispositif similaire au dispositif 1 mais qui serait dépourvu de couche 103.

En variante, on peut prévoir que chacune des couches 102 et 103 soit formée sur toute la surface du substrat 140 en omettant le masque 300. Là encore, le procédé décrit ci-dessus ne comprend pas de masque supplémentaire par rapport à un procédé de fabrication d'un dispositif similaire au dispositif 1 mais qui serait dépourvu de couche 103.

Dans le dispositif 1 de la figure 1 et le procédé de fabrication décrit en relation avec la figure 3, on tire parti du fait que les atomes de phosphore diffusent plus que les atomes d'arsenic dans le silicium. Cela permet d'obtenir une couche 103 dont le niveau de dopage diminue en s'éloignant de la couche 102, tout en conservant un niveau de dopage donné dans la couche 102 qui fixe, avec celui de la couche 101 (substrat 140), les caractéristiques de la diode 202 (figure 2), notamment sa tension d'avalanche.

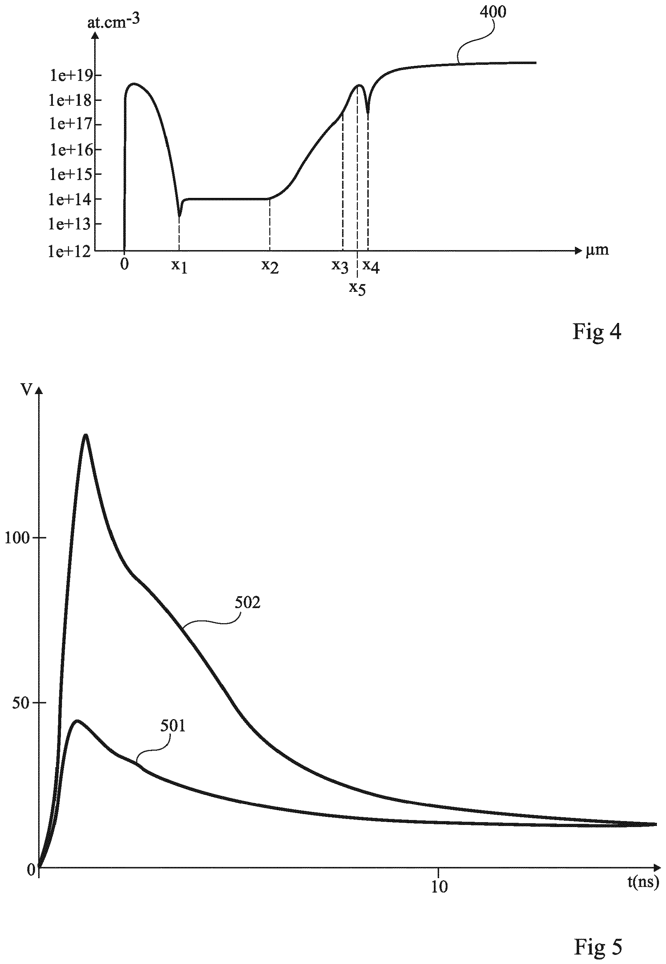

La figure 4 représente une courbe 400 illustrant la variation, le long d'un axe AA de la figure 1, du niveau de dopage en fonction de la profondeur par rapport à la face supérieure du dispositif 1, le niveau de dopage étant indiqué en ordonnée, en atomes dopants par centimètre cube (at.cm⁻³), et la profondeur étant indiquée en abscisse, en micromètres (µm). La courbe 400 correspond ici à un dispositif 1 obtenu selon le procédé décrit en relation avec la figure 3.

La région 105 s'étend en épaisseur depuis la surface supérieure du dispositif (profondeur égale à 0 µm), c'est-à-dire ici la face supérieure de la région 105, jusqu'à une profondeur x₁ d'environ 2,8 µm dans cet exemple. Dans cet exemple, le niveau de dopage maximal dans la région 105 est environ égal à 5^{∗}10¹⁸ at.cm⁻³ et décroît jusqu'à la jonction PN avec la couche 104.

La couche 104 s'étend en épaisseur depuis la profondeur x₁ jusqu'à une profondeur x₂ d'environ 7,2 µm dans cet exemple. Dans cet exemple, le niveau de dopage de la couche 204 est environ égal à 1^{∗}10¹⁴ at.cm⁻³.

La couche 103 s'étend en épaisseur depuis la profondeur x₂ jusqu'à une profondeur x₃ d'environ 10,7 µm dans cet exemple. Dans cet exemple, à la profondeur x₂, le niveau de dopage de la couche 103 est égal à celui de la couche 104, le niveau de dopage de la couche 103 augmentant jusqu'à la profondeur x₃, c'est-à-dire jusqu'à la couche 102, où il est égal à environ 3^{∗}10¹⁷ at.cm⁻³.

La couche 102 s'étend en épaisseur depuis la profondeur x₃ jusqu'à une profondeur x₄ d'environ 12 µm dans cet exemple. Dans cet exemple, le niveau de dopage de la couche 102 est maximum et environ égal à 5^{∗}10¹⁸ at.cm⁻³ au niveau d'une profondeur x₅ comprise entre x₃ et x₄ et environ égale à 11,5 µm, le niveau de dopage diminuant en se rapprochant de la jonction PN avec la couche 101, et en se rapprochant de la couche 103.

La couche 101 s'étend en épaisseur à partir de la profondeur x₄, le niveau de dopage dans la couche 101 étant égal à environ 2^{∗}10¹⁹ at.cm⁻³ dans cet exemple.

La courbe 400 illustre l'évolution du niveau de dopage pour un exemple particulier de dispositif 1, d'autres niveaux de dopage et/ou d'autres épaisseurs de couches ou régions pouvant être prévus.

A titre d'exemple, les épaisseurs des différentes couches et/ou régions du dispositif 1 peuvent être comprises :
- entre environ 2 µm et environ 5 µm, de préférence entre 2 et 5 µm, par exemple égale à environ 2,5 µm pour les régions 105 et 106 ;
- entre environ 0,5 µm et environ 3 µm, de préférence entre 0,5 et 3 µm, par exemple égale à 1 µm pour la région 107 ;
- entre environ 4 µm et environ 8 µm, de préférence entre 4 et 8 µm, par exemple égale à environ 5 µm pour la couche 104 ;
- entre environ 2 µm et environ 6 µm, de préférence entre 2 et 6 µm, par exemple égale à 3 µm pour la couche 103 ;
- entre environ 1 µm et environ 2 µm, de préférence entre 1 et 2 µm, par exemple égale à 1,5 µm pour la couche 102 ; et
- entre environ 10 µm et environ 14 µm, de préférence entre 10 et 14 µm, par exemple égale à 11 µm pour la couche 150.

A titre d'exemple, notamment dans le cas où le dispositif 1 a les dimensions indiquées ci-dessus à titre d'exemple, les niveaux de dopage des différentes couches et/ou régions du dispositif 1 peuvent être par exemple compris :
- entre environ 5^{∗}10¹⁷ at.cm⁻³ et environ 1^{∗}10¹⁹ at.cm⁻³, de préférence entre 5^{∗}10¹⁷ at.cm⁻³ et 1^{∗}10¹⁹ at.cm⁻³, par exemple environ égal à 5^{∗}10¹⁸ at.cm⁻³ pour la couche 102 ;
- entre environ 1^{∗}10¹³ at.cm⁻³ et environ 1^{∗}10¹⁵ at.cm⁻³, de préférence entre 1^{∗}10¹³ at.cm⁻³ et 1^{∗}10¹⁵ at.cm⁻³, par exemple environ égal à 1^{∗}10¹⁴ at.cm⁻³ pour la couche 104 ;
- entre environ 5^{∗}10¹⁷ at.cm⁻³ et environ 1^{∗}10¹⁹ at.cm⁻³, de préférence entre 5^{∗}10¹⁷ at.cm⁻³ et 1^{∗}10¹⁹ at.cm⁻³, par exemple environ égal à 5^{∗}10¹⁸ at.cm⁻³ pour les régions 105 et 106 ;
- entre environ 5^{∗}10¹⁷ at.cm⁻³ et environ 1^{∗}10¹⁹ at.cm⁻³, de préférence entre 5^{∗}10¹⁷ at.cm⁻³ et 1^{∗}10¹⁹ at.cm⁻³, par exemple environ égal à 5^{∗}10¹⁸ at.cm⁻³ pour la région 107 ; et
- entre environ 1^{∗}10¹⁸ at.cm⁻³ et environ 1^{∗}10²⁰ at.cm⁻³, de préférence entre 1^{∗}10¹⁸ at.cm⁻³ et 1^{∗}10²⁰ at.cm⁻³, par exemple environ égal à 3^{∗}10¹⁹ at.cm⁻³ pour la couche 101.

Le fonctionnement du dispositif 1 décrit en relation avec les figures 1 à 4 est le suivant.

On considère ici que la borne 130 du dispositif est reliée à la masse. Lorsqu'une décharge électrostatique se produit entre les bornes 120 et 130, on observe un pic de tension entre ces bornes 120 et 130. Dès que la tension entre les bornes 120 et 130 est supérieure à la somme de la tension de seuil de la diode 201 et de la tension d'avalanche de la diode 202, un courant circule de la borne 120 vers la borne 130, via les diodes 201 et 202, ce qui permet d'évacuer la décharge électrostatique vers la masse.

Dans cet exemple où le dispositif comprend les régions 106 et 107, c'est-à-dire les transistors 203 et 204, après que la diode 202 se soit mise à conduire, le transistor PNP 203 devient passant dès que le courant injecté dans sa base est suffisant. Une fois passant, le transistor 203 tire du courant de la base du transistor NPN 204 qui devient passant à son tour. Cela offre un chemin conducteur supplémentaire entre les bornes 120 et 130 pour évacuer la décharge électrostatique vers la masse.

Dans le dispositif 1, la couche 103 facilite le transfert des porteurs de charges entre la région 105 et la couche 102 lors d'une décharge électrostatique entre les bornes 120 et 130. Cela permet de réduire le temps de mise en conduction du dispositif 1, et en particulier de sa diode 202, par rapport à celui d'un dispositif similaire mais dépourvu de couche 103. Cette mise en conduction plus rapide permet que la décharge électrostatique soit évacuée ou absorbée plus rapidement, et donc que le pic de tension entre les bornes 120 et 130 soit plus faible.

Par ailleurs, en l'absence de la couche 103, les atomes dopants du substrat 140 pourraient diffuser jusque dans la couche de silicium épitaxié 150. Le dispositif correspondant aurait alors un empilement comprenant successivement la couche 101, la couche 102, une couche dopée de type P et la couche 104. Par rapport au dispositif 1, un tel dispositif pourrait bénéficier d'une capacité réduite entre les bornes 120 et 130. Toutefois, en raison des variations de fabrication, et en particulier en ce qui concerne le niveau de dopage du substrat 140, les dispersions sur la valeur de cette capacité seraient plus grandes que dans le cas du dispositif 1.

La figure 5 représente deux courbes 501 et 502 illustrant, lors d'une décharge électrostatique, l'évolution temporelle de la tension entre les bornes 120 et 130 respectivement du dispositif de commutation de la figure 1 et d'un dispositif de commutation similaire à celui de la figure 1 mais dépourvu de couche 103, la tension étant référencée à la borne 130. Dans cet exemple, les courbes 501 et 502 sont obtenues par simulation avec une décharge électrostatique d'un kilo volt conforme à la norme IEC 6100, partie 4-2.

Comme on le voit sur la figure 5, le pic de tension entre les bornes 120 et 130 du dispositif 1 (courbe 501) est plus faible, ici au moins deux fois plus faible, que le pic de tension entre les bornes 120 et 130 du dispositif correspondant à la courbe 502. Plus particulièrement, dans cet exemple, le pic de tension de la courbe 501 atteint une valeur maximale d'environ 45 V alors que le pic de tension de la courbe 502 atteint une valeur maximale d'environ 130 V. Cela résulte du fait que le dispositif 1 correspondant à la courbe 501 est mis en conduction plus rapidement que le dispositif correspondant à la courbe 502. Un circuit électronique est donc mieux protégé contre les décharges électrostatiques par le dispositif 1 que par un dispositif similaire mais dépourvu de couche 103.

En partant du dispositif correspondant à la courbe 502, pour réduire le temps de mise en conduction du dispositif, on aurait pu penser à diminuer l'épaisseur de la couche 104, c'est-à-dire l'épaisseur de la couche de silicium épitaxié 150 dans cet exemple. Toutefois, les courants de fuite dans un tel dispositif auraient été supérieurs à ceux du dispositif 1. On aurait également pu penser à doper plus fortement la couche 103 à l'arsenic. Toutefois, les défauts liés à l'implantation d'atomes d'arsenic auraient été plus nombreux et la jonction PN entre les couches 101 et 102 plus abrupte que dans le dispositif 1, ce qui aurait conduit à des courants de fuite supérieurs à ceux du dispositif 1.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, un dispositif de commutation du type de celui de la figure 1 mais dans lequel les régions 106 et 107 sont omises ou remplacées par d'autres régions semiconductrices dopées, bénéficie, comme le dispositif de la figure 1, des avantages liés à la couche 103.

Enfin, la mise en oeuvre pratique des modes de réalisation et variantes décrits est à la portée de l'homme du métier à partir des indications fonctionnelles données ci-dessus.

## Revendications

1. Dispositif de commutation (1) comprenant un empilement comportant successivement, en contact deux à deux, une troisième couche de silicium dopé de type P (101), une deuxième couche de silicium dopé à l'arsenic (102), une première couche de silicium dopé au phosphore (103) et une quatrième couche de silicium dopé de type N (104).

2. Dispositif selon la revendication 1, dans lequel le niveau de dopage de la première couche (103) diminue en s'éloignant de la deuxième couche (102) et en s'approchant de la quatrième couche (104).

3. Dispositif selon la revendication 1 ou 2, dans lequel, à l'interface entre les première (103) et quatrième (104) couches, le niveau de dopage de la première couche est égal au niveau de dopage de la quatrième couche.

4. Dispositif selon l'une quelconque des revendications 1 à 3, comprenant une première région (105) dopée de type P et disposée dans la quatrième couche (104), du côté opposé à la première couche (103).

5. Dispositif selon la revendication 4, dans lequel la troisième couche (101) est connectée à une première borne (130) du dispositif et la première région (105) est connectée à une deuxième borne (120) du dispositif.

6. Dispositif selon la revendication 4 ou 5 comprenant en outre une deuxième région (106) dopée de type P disposée dans la quatrième couche (104), du côté opposé à la première couche (103), et une troisième région (107) dopée de type N disposée dans la deuxième région, du côté opposé à la première couche.

7. Dispositif selon les revendications 5 et 6, dans lequel les deuxième (106) et troisième (107) régions sont connectées à la première borne (130) du dispositif.

8. Dispositif selon la revendication 5 ou 7, dans lequel les première (130) et deuxième (120) bornes du dispositif sont destinées à être connectées à deux bornes respectives d'un circuit à protéger contre une décharge électrostatique.

9. Dispositif selon l'une quelconque des revendications 1 à 8, comprenant une couche de silicium épitaxié (150) sur et en contact avec un substrat en silicium (140), la deuxième couche (102) étant située dans le substrat et la première couche (103) s'étendant depuis la deuxième couche jusque dans la couche de silicium épitaxié, l'épaisseur de la couche de silicium épitaxié étant de préférence comprise entre 10 et 14 µm.

10. Dispositif selon la revendication 9, dans lequel la troisième couche (101) est située dans le substrat (140), la quatrième couche (104) étant située dans la couche de silicium épitaxié (150).

11. Procédé de fabrication d'un dispositif (1) de commutation comprenant les étapes suivantes :
a) former une couche de silicium dopé à l'arsenic (102) en implantant des atomes d'arsenic dans un substrat de silicium (140) dopé de type P ;
b) former une couche de silicium dopé au phosphore (103) dans la couche de silicium dopé à l'arsenic (102) en implantant des atomes de phosphore dans la couche de silicium dopé à l'arsenic (102) ;
c) faire croître, par épitaxie à partir du substrat (140), une couche de silicium (150) dopé de type N.

12. Procédé selon la revendication 11, dans lequel l'étape a) comprend le dépôt d'un masque (300) sur le substrat (140), les implantations des étapes a) et b) étant effectuées en utilisant le masque.
